# EUROPEAN PATENT APPLICATION

(11) **EP 3 863 051 A1**
(43) Date of publication of application: **11.08.2021**
(21) Application number: 21154718.7
(22) Date of filing: 02.02.2021
(51) Int. Cl.: H01L 27/02, H01L 27/118

(54) **SEMICONDUCTOR DEVICE**

(30) Priority: 07.02.2020 US 202016785029
(71) Applicant: Renesas Electronics Corporation, Tokyo 135-0061 (JP)
(72) Inventor: YADOGUCHI, Yasuhiro, Tokyo, 135-0061 (JP)
(74) Representative: Betten & Resch

(57) **Abstract**

A semiconductor device includes first and second semiconductor layers, first and second basic logic cells, and a tap cell. Each of the first and second basic logic cells includes a gate electrode, and first to fourth diffusion layers. The tap cell includes a dummy gate pattern, fifth and sixth diffusion layers, and first and second wiring layers. The first wiring layer is electrically connected to the fifth diffusion layer. The second wiring layer is electrically connected to the sixth diffusion layer.

## Description

### BACKGROUND

The present disclosure relates to a semiconductor device having a tap cell.

In layout design of a semiconductor device, the arrangement and routing of circuit elements are determined by arranging and connecting a plurality of types of standard cells constituting a basic logical circuit using Electronic Design Automation (EDA) tools. The EDA tool is used with a database called a cell library. Information such as the logical function, electrical characteristics, and layout of the standard cell is stored in the cell library.

The standard cell includes a basic logic cell that constitutes a logic circuit, such as an inverter, an AND circuit, a flip-flop, and the like, as well as a tap cell that constitutes a tap that supplies a power supply potential to a well in which the basic logic cells are arranged.

There are disclosed techniques listed below.
[Patent Document 1] Japanese Unexamined Patent Application Publication No. 2006-253375

Patent Document 1 discloses a technique for arranging a tap cell between basic logic cells in layout design of a semiconductor device using a cell library.

### SUMMARY

In advanced Large Scale Integrations (LSIs), due to the progress of miniaturization, the influence of the quality of the pattern shape on the yield and characteristics of the LSI is increasing. Incidentally, it is known that when the periodicity of the layout pattern of the LSI is disturbed, variation in pattern shape is likely to occur at the time of transfer of each pattern.

However, the technique disclosed in Patent Document 1 is to consecutively arrange the basic logic cell and the tap cell. That is, consecutively arranging standard cells having different layout patterns impairs the periodicity of the layout patterns.

Other objects and new features will be apparent from the description of this specification and the accompanying drawings.

A semiconductor device according to one embodiment includes first and second semiconductor layers, first and second basic logic cells, and a tap cell. Each of the first and second basic logic cells includes a gate electrode, and first to fourth diffusion layers. The tap cell includes a dummy gate pattern, fifth and sixth diffusion layers, and first and second wiring layers. The first wiring layer is electrically connected to the fifth diffusion layer. The second wiring layer is electrically connected to the sixth diffusion layer.

According to one embodiment, the periodicity of the layout pattern around the tap cell is improved, and as a result, the accuracy of pattern transfer can be improved. This contributes to an improvement in yield and a reduction in variation in characteristics of a semiconductor device.

### BRIEF DESCRIPTION OF THE DRAWINGS

FIG. 1 is a plan view showing an example of a layout of a semiconductor device according to a first embodiment.
FIG. 2 is a plan view showing an example of a cell layout of the semiconductor device according to the first embodiment.
FIG. 3 is a plan view showing an example of a cell layout of the semiconductor device according to the first embodiment.
FIG. 4 is a plan view showing an example of a cell layout of a semiconductor device according to a second embodiment.
FIG. 5 is a plan view showing an example of a cell layout of a semiconductor device according to a third embodiment.
FIG. 6 is a plan view showing an example of a cell layout of a semiconductor device according to a combination of the second embodiment and third embodiment.

### DETAILED DESCRIPTION

Hereinafter, embodiments will be described in detail with reference to the drawings. In the specification and the drawings, the same or corresponding components are denoted by the same reference numerals, and a repetitive description thereof is omitted. In the drawings, for convenience of description, the configuration may be omitted or simplified.

For convenience of description, an XYZ orthogonal coordinate axis system is introduced. One direction (a first direction) and another direction (a second direction different from the first direction) orthogonal to each other in a plane parallel to the drawing are defined as an X axis direction and a Y axis direction. The direction orthogonal to the drawing is defined as a Z axis direction.

### First Embodiment

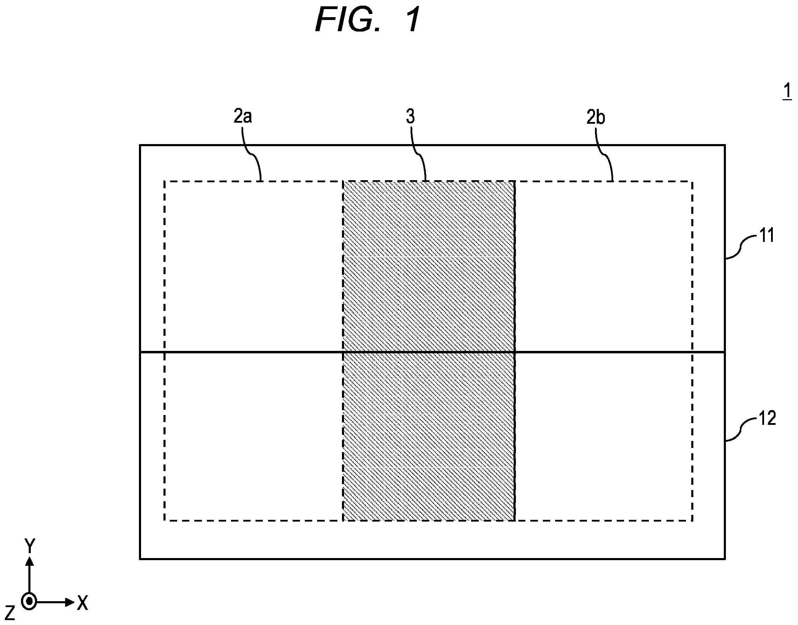

FIG. 1 is a plan view showing an example of a layout of a semiconductor device 1 according to a first embodiment. In FIG. 1, only a part of the semiconductor device 1 is shown. As shown in FIG. 1, the semiconductor device 1 includes an N-type well 11 (a first semiconductor layer) and a P-type well 12 (a second semiconductor layer) . The N-type well 11 is formed in the surface layer of the semiconductor device 1 by doping with an N-type (a first conductivity type) impurity. The P-type well 12 is formed in the surface layer of the semiconductor device 1 by doping with a P-type (a second conductivity type) impurity. The N-type well 11 and the P-type well 12 are arranged adjacent to each other in the Y axis direction. The N-type well 11 is arranged in the +Y axis direction. The P-type well 12 is arranged in the -Y axis direction.

Inverter cells 2a-2b and a tap cell 3, which are standard cells, are arranged in the semiconductor device 1. In the Z axis direction, that is, in a plan view (a top view) of the semiconductor device 1, the shapes of the respective cells are quadrangles. The cell boundaries are shown using dotted lines. Each of the inverter cells 2a-2b and the tap cell 3 is arranged across both the region of the N-type well 11 and the region of the P-type well 12 in the Y axis direction. The inverter cells 2a-2b and the tap cell 3 are arranged consecutively along the X axis direction. The tap cell 3 are arranged adjacently between the inverter cells 2a-2b.

The inverter cells 2a-2b are one of basic logic cells, and they constitute an inverter which provides the function of NOT operation. Each of the inverter cells 2a-2b has a P-channel transistor arranged in the N-type well 11, an N-channel transistor arranged in the P-type well 12, and a wiring in the cell connecting these transistors. The inverter cells 2a-2b are connected to other basic logic cells (not shown) by wirings between the cells, thereby realizing the logic function of the semiconductor device 1.

The tap cell 3 is provided to supply the first power supply potential VDD on the high potential side and the second power supply potential GND on the low potential side to the N-type well 11 and the P-type well 12 in which the inverter cells 2a-2b are arranged. The arrangement density of the tap cell 3 in the semiconductor device 1 is determined so that power supply capacity to the N-type well 11, the P-type well 12, and the like can be obtained.

In FIG. 1, only three cells, i.e., the inverter cells 2a-2b and the tap cell 3, are shown, but standard cells (not shown) are arranged outside the inverter cells 2a-2b. That is, the semiconductor device 1 includes a cell column in which a plurality of the standard cells is arranged along the X axis.

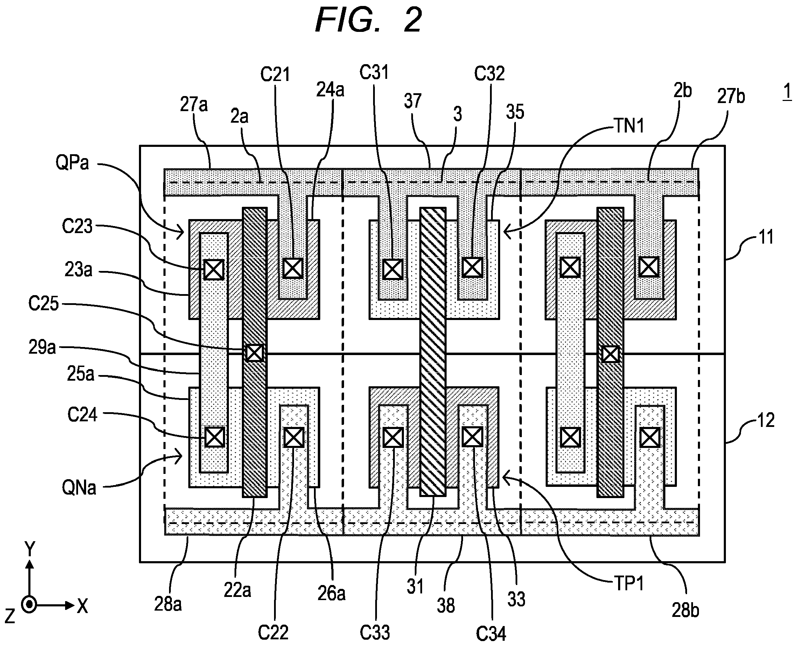

Next, an example of a layout of each cell will be described with reference to FIG. 2. FIG. 2 is a plan view showing an example of a cell layout of the semiconductor device 1 according to the first embodiment. In FIG. 2, the layouts of the inverter cells 2a-2b and the tap cell 3 are shown in detail. Since the layout of the two inverter cells 2a-2b are the same, only the layout of the inverter cell 2a will be described here.

As shown in FIG. 2, the inverter cell 2a (a first basic logic cell or a first inverter cell) includes a P-channel MOS transistor QPa provided in the N-type well 11 and an N-channel MOS transistor QNa provided in the P-type well 12. The P-channel MOS transistor QPa and the N-channel MOS transistor QNa are arranged side by side in the Y axis direction.

The P-channel MOS transistor QPa has a gate electrode 22a, and P+ diffusion layers 23a and 24a (first and second diffusion layers). The gate electrode 22a is formed above the N-type well 11 via an insulating film (not shown). For example, the gate electrode 22a is composed of a polysilicon layer. In the X axis direction, the P+ diffusion layers 23a and 24a are arranged at both sides of the gate electrode 22a. In other words, the P+ diffusion layers 23a and 24a are arranged to sandwich the region of the N-type well 11 covered by the gate electrode 22a. The P+ diffusion layers 23a and 24a are formed in the surface layer of the N-type well 11 by doping with a P-type impurity. The P-type impurity concentration of the P+ diffusion layers 23a and 24a is set to be larger than the P-type impurity concentration of the P-type well 12.

The P+ diffusion layers 23a and 24a constitute a source and a drain of the P-channel MOS transistor QPa. For example, the P+ diffusion layer 24a serves as the source of the P-channel MOS transistor QPa, and the P+ diffusion layer 23a serves as the drain of the P-channel MOS transistor QPa. The surface layer of the N-type well 11 covered by the gate electrode 22a functions as a channel layer of the P-channel MOS transistor QPa.

The N-channel MOS transistor QNa has the gate electrode 22a and N+ diffusion layers 25a and 26a (third and fourth diffusion layers). The gate electrode 22a is formed above the P-type well 12 via the insulating film (not shown). That is, the gate electrode 22a of the inverter cell 2a extends in the Y axis direction over both the N-type well 11 and the P-type well 12, and is formed as a shared gate electrode of the P-channel MOS transistor QPa and the N-channel MOS transistor QNa. In the X axis direction, the N+ diffusion layers 25a and 26a are arranged at both sides of the gate electrode 22a. In other words, the N+ diffusion layers 25a and 26a are arranged to sandwich the region of the P-type well 12 covered by the gate electrode 22a. The N+ diffusion layers 25a and 26a are formed in the surface layer of the P-type well 12 by doping with an N-type impurity. The N-type impurity concentration of the N+ diffusion layers 25a and 26a is set to be larger than the N-type impurity concentration of the N well 11.

The N+ diffusion layers 25a and 26a constitute a source and a drain of the N-channel MOS transistor QNa. For example, the N+ diffusion layer 26a serves as the source of the N-channel MOS transistor QNa, and the N+ diffusion layer 25a serves as the drain of the N-channel MOS transistor QNa. The surface layer of the P-type well 12 covered by the gate electrode 22a functions as a channel layer of the N-channel MOS transistor QNa.

The inverter cell 2a includes a first wiring layer 27a for supplying the first power supply potential VDD to the P-channel MOS transistor QPa, a second wiring layer 28a for supplying the second power supply potential GND to the N-channel MOS transistor QNa, and a third wiring layer 29a for connecting the output of the P-channel MOS transistor QPa and the output of the N-channel MOS transistor QNa. The first wiring layer 27a, the second wiring layer 28a, and the third wiring layer 29a are formed as metal layers located above the layer in which the gate electrode 22a is formed in the Z axis direction. The first wiring layer 27a is electrically connected to a first power supply terminal (not shown) that receives the first power supply potential VDD from the outside of the semiconductor device 1. That is, the first wiring layer 27a is applied with the first power supply potential VDD. The second wiring layer 28a is electrically connected to a second power supply terminal (not shown) that receives the second power supply potential GND from the outside of the semiconductor device 1. That is, the second wiring layer 28a is applied with the second power supply potential GND.

The first wiring layer 27a has a portion extending in the X axis direction, and a portion extending in the Y axis direction branching from the portion extending in the X axis direction. The portion extending in the X axis direction of the first wiring layer 27a is electrically connected to a first wiring layer 37 included in the tap cell 3. A part of the portion extending in the Y axis direction of the first wiring layer 27a is formed above the P+ diffusion layer 24a, and a contact hole C21 is provided therein. The first wiring layer 27a is electrically connected to the P+ diffusion layer 24a via the contact hole C21. The contact hole in the drawing is indicated by an "x" mark.

The second wiring layer 28a has a portion extending in the X axis direction, and a portion extending in the Y axis direction branching from the portion extending in the X axis direction. The portion extending in the X axis direction of the second wiring layer 28a is electrically connected to a second wiring layer 38 included in the tap cell 3. A part of the portion extending in the Y axis direction of the second wiring layer 28a is formed above the N+ diffusion layer 26a, and a contact hole C22 is provided therein. The second wiring layer 28a is electrically connected to the N+ diffusion layer 26a via the contact hole C22.

The third wiring layer 29a extends in the Y axis direction over both the N-type well 11 side and the P-type well 12 side. A part of the third wiring layer 29a is formed above the P+ diffusion layer 23a, and a contact hole C23 is provided therein. The third wiring layer 29a is electrically connected to the P+ diffusion layer 23a via the contact hole C23. A part of the third wiring layer 29a is formed above the N+ diffusion layer 25a, and a contact hole C24 is provided therein. The third wiring layer 29a is electrically connected to the N+ diffusion layer 25a via the contact hole C24.

A contact hole C25 is provided in the gate electrode 22a common to the P-channel MOS transistor QPa and the N-channel MOS transistor QNa, and the contact hole C25 becomes a part of an input unit of the inverter composed of the P-channel MOS transistor and the N-channel MOS transistor. That is, a predetermined potential corresponding to an input signal to the inverter cell 2a is applied to the gate electrode 22a via the contact hole C25.

As shown in FIG. 2, the tap cell 3 includes a first tap TN1 provided in the N-type well 11 and a second tap TP1 provided in the P-type well 12. The first tap TN1 and the second tap TP1 are arranged side by side in the Y axis direction.

The first tap TN1 has a function of supplying the first power supply potential VDD to the N-type well 11. The first tap TN1 has an N+ diffusion layer 35 (a fifth diffusion layer), the first wiring layer 37 and a first dummy gate pattern 31. The N+ diffusion layer 35 is formed in the surface layer of the N-type well 11 by doping with an N-type impurity. The N-type impurity concentration of the N+ diffusion layer 35 is set to be larger than the N-type impurity concentration of the N-type well 11. The first wiring layer 37 is formed as a metal layer located above the layer in which the first dummy gate pattern 31 is formed in the Z axis direction. The first wiring layer 37 is electrically connected to the first power supply terminal (not shown) of the semiconductor device 1. That is, the first wiring layer 37 is applied with the first power supply potential VDD.

The first wiring layer 37 has a portion extending in the X axis direction, and portions extending in the Y axis direction branching from the portion extending in the X axis direction. The portion extending in the X axis direction of the first wiring layer 37 is electrically connected to the first wiring layer 27a included in the inverter cell 2a. The part extending in the X axis direction of the first wiring layer 37 is also electrically connected to a first wiring layer 27b included in the inverter cell 2b.

The first wiring layer 37 has two portions extending in the Y axis direction. The portions extending in the Y axis direction of the first wiring layer 37 are formed at both sides of the first dummy gate pattern 31 in the X axis direction. Parts of the portions extending in the Y axis direction of the first wiring layer 37 are formed above the N+ diffusion layer 35, respectively. A contact hole C31 is provided in the part of the portion extending in the Y axis direction of the first wiring layer 37 formed at the -X axis direction side of the first dummy gate pattern 31. A contact hole C32 is provided in the part of the portion extending in the Y axis direction of the first wiring layer 37 formed at the +X axis direction side of the first dummy gate pattern 31. The portions extending in the Y axis direction of the first wiring layer 37 is electrically connected to the N+ diffusion layer 35 via the contact holes C31-C32.

In other words, the N+ diffusion layer 35 has a first region covered by the first dummy gate pattern 31, and second and third regions not covered by the first dummy gate pattern 31. The second and third regions of the N+ diffusion layer 35 are arranged to sandwich the first region of the N+ diffusion layer 35. The first wiring layer 37 is electrically connected to the second and third regions of the N+ diffusion layer 35 via the contact holes C31-C32. Thus, the tap TN1 supplies the first power supply potential VDD to the N-type well 11 via the first wiring layer 37, the contact holes C31-C32, and the N+ diffusion layer 35.

The first dummy gate pattern 31 is a dummy pattern which is not related to a function of supplying the first power supply potential VDD to the N-type well 11, that is, a function of the first tap TN1. Therefore, for example, a predetermined potential is not supplied to the first dummy gate pattern 31, and the potential of the first dummy gate pattern 31 becomes floating.

The first dummy gate pattern 31 is formed above the N+ diffusion layer 35 via an insulating film (not shown). For example, the first dummy gate pattern 31 is composed of a polysilicon layer. In the X axis direction, the N+ diffusion layer 35 is arranged at both sides of the first dummy gate pattern 31. Therefore, in the layout of the first tap TN1, the first dummy gate pattern 31 corresponds to a gate electrode of a MOS transistor, and the N+ diffusion layer 35 corresponds to a source and drain of the MOS transistor. In this manner, the first tap TN1 has a transistor-type layout shape.

The second tap TP1 has a function of supplying the second power supply potential GND to the P-type well 12. The second tap TP1 has a P+ diffusion layer 33 (a sixth diffusion layer), a second wiring layer 38, and the first dummy gate pattern 31. The P+ diffusion layer 33 is formed in the surface layer of the P-type well 12 by doping with a P-type impurity. The P-type impurity concentration of the P+ diffusion layer 33 is set to be larger than the P-type impurity concentration of the P-type well 12. The second wiring layer 38 is formed as a metal layer located above the layer in which the first dummy gate pattern 31 is formed in the Z axis direction. The second wiring layer 38 is electrically connected to the second power supply terminal (not shown) of the semiconductor device 1. That is, the second wiring layer 38 is applied with the second power supply potential GND.

The second wiring layer 38 has a portion extending in the X axis direction, and portions extending in the Y axis direction branching from the portion extending in the X axis direction. The portion extending in the X axis direction of the second wiring layer 38 is electrically connected to the second wiring layer 28a included in the inverter cell 2a. The portion extending in the X axis direction of the second wiring layer 38 is also electrically connected to a second wiring layer 28b included in the inverter cell 2b.

The second wiring layer 38 has two portions extending in the Y axis direction. The portions extending in the Y axis direction of the second wiring layer 38 are formed at both sides of the first dummy gate pattern 31 in the X axis direction. Parts of the portions extending in the Y axis direction of the second wiring layer 38 are formed above the P+ diffusion layer 33, respectively. A contact hole C33 is provided in the part of the portion extending in the Y axis direction of the second wiring layer 38 formed at the -X axis direction side of the first dummy gate pattern 31. A contact hole C34 is provided in the part of the portion extending in the Y axis direction of the second wiring layer 38 formed at the +X axis direction side of the first dummy gate pattern 31. The portions extending in the Y axis direction of the second wiring layer 38 is electrically connected to the P+ diffusion layer 33 via the contact holes C33-C34.

In other words, the P+ diffusion layer 33 has a first region covered by the first dummy gate pattern 31, and second and third regions not covered by the first dummy gate pattern 31. The second and third regions of the P+ diffusion layer 33 are arranged to sandwich the first region of the P+ diffusion layer 33. The second wiring layer 38 is electrically connected to the second and third regions of the P+ diffusion layer 33 via the contact holes C33-C34. Thus, the tap TP1 supplies the second power supply potential GND to the P-type well 12 via the second wiring layer 38, the contact holes C33-C34, and the P+ diffusion layer 33.

The first dummy gate pattern 31 is a dummy pattern which is not related to a function of supplying the second power supply potential GND to the P-type well 12, that is, a function of the second tap TP1.

The first dummy gate pattern 31 is formed above the P+ diffusion layer 33 via the insulating film (not shown). That is, the dummy gate pattern 31 of the tap cell 3 extends in the Y axis direction over both the N-type well 11 and the P-type well 12, and is formed as a shared dummy gate pattern of the first tap TN1 and the second tap TP1. In the X axis direction, the P+ diffusion layers 33 is arranged at both sides of the first dummy gate pattern 31. Therefore, in the layout of the second tap TP1, the first dummy gate pattern 31 corresponds to a gate electrode of a MOS transistor, and the P+ diffusion layer 33 corresponds to a source and drain of the MOS transistor. In this manner, the second tap TP1 has a transistor-type layout shape.

The shape of the first dummy gate pattern 31 common to the first tap TN1 and the second tap TP1 is a shape of a pattern similar to the gate electrode 22a of the inverter cell 2a. Further, the first dummy gate pattern 31 is made of the same material as the gate electrode 22a.

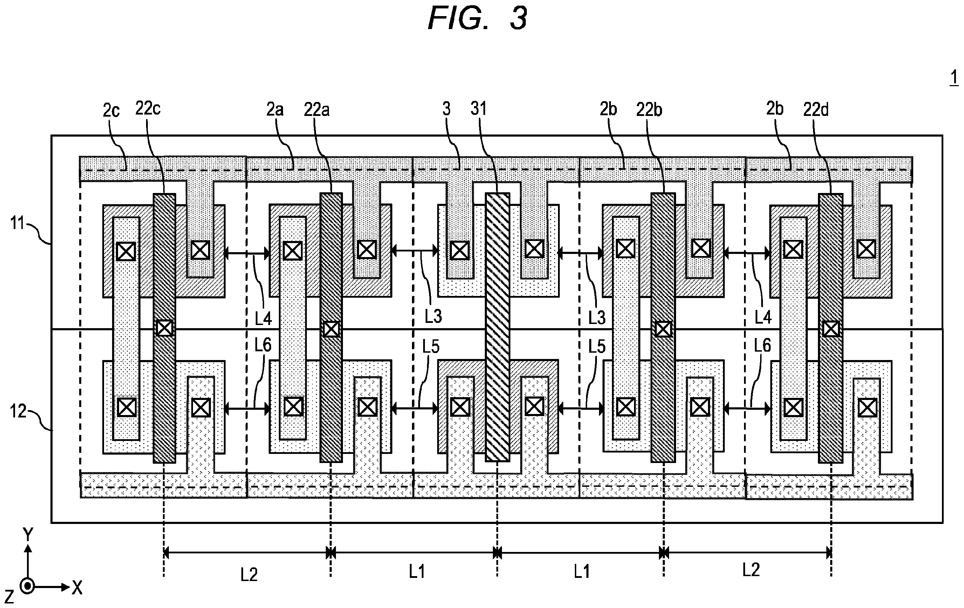

FIG. 3 is a plan view showing an example of a cell layout of the semiconductor device 1 according to the first embodiment. In FIG. 3, the inverter cells 2a-2d and the tap cell 3, which are standard cells, are arranged side by side in the Y axis direction in the order of the inverter cells 2c and 2a, the tap cell 3, and the inverter cells 2b and 2d.

As described above, the tap cell 3 includes the first tap TN1 and the second tap TP1 having the transistor-type layout shape, and includes the first dummy gate pattern 31 having the pattern shape similar to the gate electrodes 22a-22d of the inverter cells 2a-2d. Therefore, as shown in FIG. 3, the first dummy gate pattern 31 of the tap cell 3 is arranged side by side in the X axis direction in the same manner as the gate electrodes 22a-22d of the inverter cells 2a-2d. That is, the first dummy gate pattern 31, which is not necessary for the function of supplying the power supply potential to the N-type well 11 and the P-type well 12, is arranged in the tap cell 3, so that the pattern shapes of the gate electrodes 22a-22d are repeatedly arranged in the region of five standard cells arranged side by side in the X axis direction. As a result, even when a tap cell is arranged between inverter cells, the periodicity of the layout pattern around the tap cell, specifically, the periodicity of the gate electrode pattern of the inverter cell is maintained.

As described above, according to the first embodiment, the first dummy gate pattern 31 of the tap cell 3 is a dummy pattern arranged to maintain the periodicity of the layout patterns of the gate electrodes 22a-22d in the periphery of the tap cell 3. The pattern transfer of the gate electrodes 22a-22d and the first dummy gate pattern 31 in which the periodicity of the layout pattern is maintained is performed by the same process, thereby suppressing variation in the pattern shape. As a result, the yield of the semiconductor device 1 can be improved, and variations in characteristics of the semiconductor device 1 can be suppressed.

As shown in FIG. 3, it is preferable to adjust the size of the tap cell 3, the arrangement position of the first dummy gate pattern 31 in the tap cell 3, and the shape of the first dummy gate pattern 31 so that the distance L1 between the first dummy gate pattern 31 and the gate electrode 22a (22b) is substantially the same as the distance L2 between the gate electrode 22a (22b) and the gate electrode 22c (22d). Specifically, it is preferable that the length of the tap cell 3 in the X axis direction is substantially the same as the length of the inverter cells 2a-2d in the X axis direction. It is preferable that the arrangement position of the first dummy gate pattern 31 in the tap cell 3 and the arrangement position of the gate electrodes 22a-22d in the inverter cells 2a-2d are substantially the same. It is preferable that the shape of the first dummy gate pattern 31 and the shape of the gate electrode 22 are substantially the same.

Also, by adjusting the shapes and the arrangement position in the tap cell 3 of the N+ diffusion layer 35 and the P+ diffusion layer 33, it is possible to maintain the periodicity of the layout pattern around the tap cell 3. For example, as shown in FIG. 3, the distance L3 between the N+ diffusion layer of the tap cell 3 and the P+ diffusion layer of the inverter cell 2a (2b) is set to be substantially the same as the distance L4 between the P+ diffusion layer of the inverter cell 2a (2b) and the P+ diffusion layer of the inverter cell 2c (2d). Further, the distance L5 between the P+ diffusion layer of the tap cell 3 and the N+ diffusion layer of the inverter cell 2a (2b) is set to be substantially the same as the distance L6 between the N+ diffusion layer of the inverter cell 2a (2b) and the N+ diffusion layer of the inverter cell 2c (2d).

In the above description, the inverter cell is taken as an example of the basic logic cell adjacent to the tap cell, but the present disclosure is not limited thereto. The basic logic cell adjacent to the tap cell may be a cell constituting a logic circuit including an N-channel MOS transistor and a P-channel MOS transistor, such as a buffer, AND circuit, NAND circuit, OR circuit, NOR circuit, or a flip-flop. In the tap cell, a first dummy gate pattern similar to the gate electrode of the transistor included in the basic logic cell is arranged.

In addition, although an example has been described in which there are two portions extending in the Y axis direction of the first wiring layer 37, there may be one portion. The same applies to the second wiring layer 38.

Although the semiconductor device 1 including the N-type well 11 and the P-type well 12 is illustrated, the semiconductor device 1 does not have to be configured as such a twin well. For example, the semiconductor device 1 may have a configuration in which an N-type well is provided in a P-type semiconductor substrate.

### Second Embodiment

Next, a second embodiment will be described. A semiconductor device according to the second embodiment differs from the semiconductor device 1 according to the first embodiment in that the sizes of the N+ diffusion layer and the P+ diffusion layer included in the tap cell are set small.

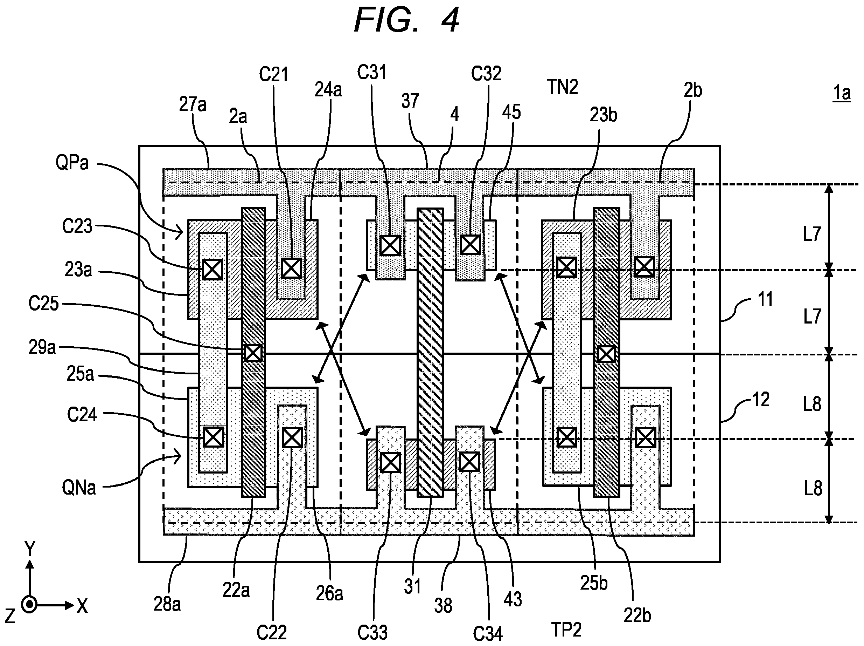

FIG. 4 is a plan view showing an example of a cell layout of a semiconductor device 1a according to the second embodiment. As shown in FIG. 4, in the semiconductor device 1a, the tap cell 3 of the semiconductor device 1 is changed to a tap cell 4. In addition, the first tap TN1, the second tap TP1, the N+ diffusion layer 35, and the P+ diffusion layer 33 of the tap cell 3 of the semiconductor device 1 are changed to a first tap TN2, a second tap TP2, an N+ diffusion layer 45, and a P+ diffusion layer 43, respectively.

The tap cell 4 has the first tap TN2 provided in the N-type well 11 and the second tap TP2 provided in the P-type well 12. The first tap TN2 has the N+ diffusion layer 45, and supplies the first power supply potential VDD to the N-type well 11 via the first wiring layer 37, the contact holes C31-C32, and the N+ diffusion layer 45.

The size of the N+ diffusion layer 45 is set smaller than the maximum possible size on the region of the N-type well 11 in the tap cell 4. For example, as shown in FIG. 4, the length of the N+ diffusion layer 45 having a quadrangle shape in the Y axis direction is preferably set to be shorter than half (length L7) of the distance from the cell boundary (a first cell boundary) on the +Y axis direction side (N-type well 11 side) of the tap cell 4 to the well boundary between the N-type well 11 and the P-type well 12. In this case, the size of the N+ diffusion layer 45 is smaller than half the maximum possible size on the region of the N-type well 11 in the tap cell 4.

Further, the N+ diffusion layer 45 is arranged at a position closer to the cell boundary of the tap cell 4 on the +Y axis direction side than the well boundary between the N-type well 11 and the P-type well 12. For example, as shown in FIG. 4, when the length of the N+ diffusion layer 45 in the Y axis direction is made shorter than L7, it is preferable that the N+ diffusion layer 45 is arranged at a position at which there is a distance of the length L7 or more from the well boundary between the N-type well 11 and the P-type well 12. In this manner, as shown in FIG. 4, the distance between the N+ diffusion layer 45 and the N+ diffusion layer 26a and the distance between the N+ diffusion layer 45 and the N+ diffusion layer 25b are sufficiently obtained, respectively.

The N+ diffusion layer 45 of the tap cell 4 and the N+ diffusion layer 26a of the inverter cell 2a are both formed by doping with an N-type impurity. Therefore, if the distance between the N+ diffusion layer 45 and the N+ diffusion layer 26a cannot be sufficiently obtained, the N+ diffusion layer 45 and the N+ diffusion layer 26a may become conductive.

However, since the N+ diffusion layer 45 of the semiconductor device 1a is set to be small in size and arranged at a position closer to the cell boundary on the +Y axis direction side of the tap cell 4 than the well boundary between the N-type well 11 and the P-type well 12, the distance between the N+ diffusion layer 45 and the N+ diffusion layer 26a can be sufficiently obtained. Therefore, conduction between the N+ diffusion layer 45 and the N+ diffusion layer 26a can be suppressed. The same applies to the relationship between the N+ diffusion layer 45 of the tap cell 4 and the N+ diffusion layer 25b of the inverter cell 2b.

Note that the N+ diffusion layer 45 is formed on the N-type well 11 to which the first power supply potential VDD is supplied, and the N+ diffusion layers 26a and 25b are formed on the P-type well 12 to which the second power supply potential GND is supplied. Therefore, if the N+ diffusion layer 45 and the N+ diffusion layer 26a, or the N+ diffusion layer 45 and the N+ diffusion layer 25b are electrically connected to each other, a large current flows through the semiconductor device 1a, and as a result, a transistor included in the semiconductor device 1a may be damaged. Accordingly, it is necessary to pay particular attention to the fact that the diffusion layers of the same conductivity type formed on the wells of different conductivity types, i.e., the N+ diffusion layer 45 and the N+ diffusion layer 26a, or the N+ diffusion layer 45 and the N+ diffusion layer 25b, are electrically connected to each other.

The second tap TP2 has the P+ diffusion layer 43, and supplies the second power supply potential GND to the P-type well 12 via the second wiring layer 38, the contact holes C33-C34, and the P+ diffusion layer 43.

The size of the P+ diffusion layer 43 is set smaller than the maximum possible size on the region of the P-type well 12 in the tap cell 4. For example, as shown in FIG. 4, the length of the P+ diffusion layer 43 having a quadrangle shape in the Y axis direction is preferably set to be shorter than half (length L8) of the distance from the cell boundary (a second cell boundary) on the -Y axis direction side (P-type well 12 side) of the tap cell 4 to the well boundary between the N-type well 11 and the P-type well 12. In this case, the size of the P+ diffusion layer 43 is smaller than half the maximum possible size on the region of the P-type well 12 in the tap cell 4.

Further, the P+ diffusion layer 43 is arranged at a position closer to the cell boundary of the tap cell 4 on the -Y axis direction side than the well boundary between the N-type well 11 and the P-type well 12. For example, as shown in FIG. 4, when the length of the P+ diffusion layer 43 in the Y axis direction is made shorter than L8, it is preferable that the P+ diffusion layer 43 is arranged at a position at which there is a distance of the length L8 or more from the well boundary between the N-type well 11 and the P-type well 12. In this manner, as shown in FIG. 4, the distance between the P+ diffusion layer 43 and the P+ diffusion layer 24a and the distance between the P+ diffusion layer 43 and the P+ diffusion layer 23b are sufficiently obtained, respectively.

The P+ diffusion layer 43 of the tap cell 4 and the P+ diffusion layer 24a of the inverter cell 2a are both formed by doping a P-type impurity. Therefore, if the distance between the P+ diffusion layer 43 and the P+ diffusion layer 24a cannot be sufficiently obtained, the P+ diffusion layer 43 and the P+ diffusion layer 24a may become conductive.

However, since the P+ diffusion layer 43 of the semiconductor device 1a is set to be small in size and arranged at a position closer to the cell boundary on the -Y axis direction side of the tap cell 4 than the well boundary between the N-type well 11 and the P-type well 12, the distance between the P+ diffusion layer 43 and the P+ diffusion layer 24a can be sufficiently obtained. Therefore, conduction between the P+ diffusion layer 43 and the P+ diffusion layer 24a can be suppressed. The same applies to the relationship between the P+ diffusion layer 43 of the tap cell 4 and the P+ diffusion layer 23b of the inverter cell 2b.

Note that the P+ diffusion layer 43 is formed on the P-type well 12 to which the second power supply potential GND is supplied, and the P+ diffusion layers 24a and 23b are formed on the N-type well 11 to which the first power supply potential VDD is supplied. Therefore, if the P+ diffusion layer 43 and the P+ diffusion layer 24a, or the P+ diffusion layer 43 and the P+ diffusion layer 23b are electrically connected to each other, a large current flows through the semiconductor device 1a, and as a result, a transistor included in the semiconductor device 1a may be damaged. Accordingly, it is necessary to pay particular attention to the fact that the diffusion layers of the same conductivity type formed on the wells of different conductivity types, i.e., the P+ diffusion layer 43 and the P+ diffusion layers 24a, or the P+ diffusion layer 43 and the P+ diffusion layer 23b, are electrically connected to each other.

As described above, according to the second embodiment, the first tap TN2 having the transistor-type layout shape is set to be small in size and arranged at a position closer to the cell boundary on the +Y axis direction side of the tap cell 4 in the +Y axis direction than the well boundary between the N-type well 11 and the P-type well 12. Further, the second tap TP2 having the transistor-type layout shape is set to be small in size and arranged at a position closer to the cell boundary on the -Y axis direction side of the tap cell 4 than the well boundary between the N-type well and the P-type well. With such a layout shape of the first tap TN2 and the layout shape of the second tap TP2, it is possible to suppress conduction between the same type of diffusion layers while maintaining the periodicity of the layout pattern around the tap cell 4.

### Third Embodiment

Next, a third embodiment will be described. A semiconductor device according to the third embodiment differs from the semiconductor device 1 according to the first embodiment in that the number of first dummy gate patterns included in the tap cell is plural.

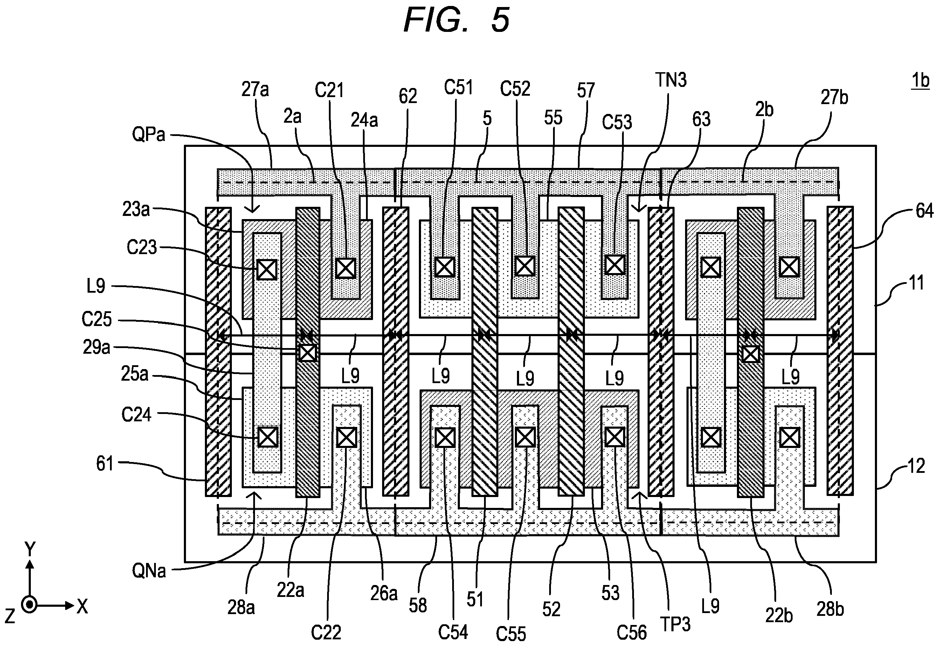

FIG. 5 is a plan view showing an example of a cell layout of a semiconductor device 1b according to the third embodiment. As shown in FIG. 5, in the semiconductor device 1b, the tap cell 3 of the semiconductor device 1 is changed to a tap cell 5. The semiconductor device 1b includes second dummy gate patterns 61-64 in addition to the layout of the semiconductor device 1.

The tap cell 5 includes a first tap TN3 provided in the N-type well 11 and a second tap TP3 provided in the P-type well 12. The first tap TN3 and the second tap TP3 are arranged side by side in the Y axis direction.

The first tap TN3 has a function of supplying the first power supply potential VDD to the N-type well 11. The first tap TN3 includes an N+ diffusion layer 55, a first wiring layer 57, and first dummy gate patterns 51-52. The N+ diffusion layer 55 is formed in the surface layer of the N-type well 11 by doping with an N-type impurity. The N-type impurity concentration of the N+ diffusion layer 55 is set to be larger than the N-type impurity concentration of the N-type well 11. In addition, since the N+ diffusion layer 55 is formed to be long in the X axis direction, the size of the N+ diffusion layer 55 is correspondingly large.

The first wiring layer 57 is formed as a metal layer located above the layer in which the first dummy gate patterns 51-52 are formed in the Z axis direction. The first wiring layer 57 is electrically connected to a first power supply terminal (not shown) of the semiconductor device 1b. That is, the first wiring layer 57 is applied with the first power supply potential VDD.

The first wiring layer 57 has a portion extending in the X axis direction and portions extending in the Y axis direction branching from the portion extending in the X axis direction. The portion extending in the X axis direction of the first wiring layer 57 is electrically connected to the first wiring layer 27a included in the inverter cell 2a and the first wiring layer 27b included in the inverter cell 2b.

The first wiring layer 57 has three portions extending in the Y axis direction. The portions extending in the Y axis direction of the first wiring layer 57 are formed at both sides of the first dummy gate patterns 51-52, respectively, in the X axis direction. That is, the portions extending in the Y axis direction of the first wiring layer 57 and the first dummy gate patterns 51-52 are alternately arranged in the X axis direction.

Parts of the portions extending in the Y axis direction of the first wiring layer 57 are formed above the N+ diffusion layer 55, respectively. A contact hole C51 is provided in the part of the portion extending in the Y axis direction of the first wiring layer 57 formed at the -X axis direction side of the first dummy gate pattern 51. A contact hole C52 is provided in the part of the portion extending in the Y axis direction of the first wiring layer 57 formed between the first dummy gate patterns 51-52. A contact hole C53 is provided in the part of the portion extending in the Y axis direction of the first wiring layer 57 formed at the +X axis direction side of the first dummy gate pattern 52. The first wiring layer 57 is electrically connected to the N+ diffusion layer 55 via the contact holes C51-C53. Thus, the first tap TN3 supplies the first power supply potential VDD to the N-type well 11 via the first wiring layer 57, the contact holes C51-C53, and the N+ diffusion layer 55.

The size of the N+ diffusion layer 55 of the first tap TN3 is larger than that of the N+ diffusion layer 35 of the first tap TN1. Also, the number of the contact holes connected to the N+ diffusion layer 55 of the first tap TN3 is larger than that of the contact holes connected to the N+ diffusion layer 35 of the first tap TN1. That is, the first tap TN3 of the semiconductor device 1b has a higher capability of supplying the first power supply potential VDD to the N-type well 11 than the first tap TN1 of the semiconductor device 1. Therefore, the potential of the N-type well 11 of the semiconductor device 1b is more stable than that of the N-type well 11 of the semiconductor device 1.

The first dummy patterns 51-52 are dummy patterns that are not related to a function of supplying the first power supply potential VDD to the N-type well 11, that is, a function of the first tap TN3. Therefore, for example, a predetermined potential is not supplied to the first dummy gate patterns 51-52, and the potentials of the first dummy gate patterns 51-52 become floating.

The first dummy gate patterns 51-52 are formed above the N+ diffusion layer 55 via an insulating film (not shown), respectively. For example, the first dummy gate patterns 51-52 are composed of a polysilicon layer. Since the N+ diffusion layers 55 are arranged at both sides of each of the first dummy gate patterns 51-52 in the X axis direction, the first tap TN3 has a transistor-type layout shape.

The second tap TP3 has a function of supplying the second power supply potential GND to the P-type well 12. The second tap TP3 includes a P+ diffusion layer 53, a second wiring layer 58, and the first dummy gate patterns 51-52. The P+ diffusion layer 53 is formed in the surface layer of the P-type well 12 by doping with a P-type impurity. The P-type impurity concentration of the P+ diffusion layer 53 is set to be larger than the P-type impurity concentration of the P-type well 12. In addition, since the P+ diffusion layer 53 is formed to be long in the X axis direction, the size of the P+ diffusion layer 53 is correspondingly large.

The second wiring layer 58 is formed as a metal layer located above the layer in which the first dummy gate patterns 51-52 are formed in the Z axis direction. The second wiring layer 58 is electrically connected to a second power supply terminal (not shown). That is, the second wiring layer 58 is applied with the second power supply potential GND.

The second wiring layer 58 has a portion extending in the X axis direction, and portions extending in the Y axis direction branching from the portion extending in the X axis direction. The portion extending in the X axis direction of the second wiring layer 58 is electrically connected to the second wiring layer 28a included in the inverter cell 2a and the second wiring layer 28b included in the inverter cell 2b.

The second wiring layer 58 has three portions extending in the Y axis direction. The portions extending in the Y axis direction of the second wiring layer 58 are formed at both sides of the first dummy gate patterns 51-52, respectively, in the X axis direction. That is, the portions extending in the Y axis direction of the second wiring layer 58 and the first dummy gate patterns 51-52 are alternately arranged in the X axis direction.

Parts of the portions extending in the Y axis direction of the second wiring layer 58 are formed above the P+ diffusion layer 53, respectively. A contact hole C54 is provided in the part of the portion extending in the Y axis direction of the second wiring layer 58 formed at the -X axis direction side of the first dummy gate pattern 51. A contact hole C55 is provided in the part of the portion extending in the Y axis direction of the second wiring layer 58 formed between the first dummy gate patterns 51-52. A contact hole C56 is provided in the part of the portion extending in the Y axis direction of the second wiring layer 58 formed at the +X axis direction side of the first dummy gate pattern 52. The second wiring layer 58 is electrically connected to the P+ diffusion layer 53 via the contact holes C54-C56. Thus, the second tap TP3 supplies the second power supply potential GND to the P-type well 12 via the second wiring layer 58, the contact holes C54-C56, and the P+ diffusion layer 53.

The size of the P+ diffusion layer 53 of the first tap TP3 is larger than that of the P+ diffusion layer 33 of the first tap TP1. Also, the number of the contact holes connected to the P+ diffusion layer 53 of the first tap TP3 is larger than that of the contact holes connected to the P+ diffusion layer 33 of the first tap TP1. That is, the second tap TP3 of the semiconductor device 1b has a higher capability of supplying the second power supply potential GND to the P-type well 12 than the second tap TP1 of the semiconductor device 1. Therefore, the potential of the P-type well 12 of the semiconductor device 1b is more stable than that of the P-type well 12 of the semiconductor device 1.

The first dummy gate patterns 51-52 are dummy patterns that are not related to a function of supplying the second power supply potential GND to the P-type well 12, that is, a function of the second tap TP3.

The first gate dummy patterns 51-52 are formed above the P+ diffusion layer 53 via an insulating film (not shown), respectively. That is, the dummy gate patterns 51-52 of the tap cell 5 extend in the Y axis direction over both the N-type well 11 and the P-type well 12, and are formed as a shared dummy gate pattern of the first tap TN3 and the second tap TP3. In the X axis direction, the P+ diffusion layers 33 is arranged at both sides of each of the first dummy gate patterns 51-52. Therefore, the second tap TP3 has a transistor-type layout shape.

The shapes of the first dummy gate patterns 51-52 common to the first tap TN3 and the second tap TP3 are a shape of a pattern similar to the gate electrode 22a of the inverter cell 2a. Further, the first dummy gate patterns 51-52 are made of the same material as the gate electrode 22a.

Since the tap cell 5 has a layout that is long in the X axis direction, the tap cell 5 has a layout in which a plurality of first dummy gate patterns are arranged. In FIG. 5, the example in which the number of the first dummy gate patterns is two is shown, but the present disclosure is not limited thereto. The number of the first dummy gate patterns is determined depending on the length of the first tap cell 5 in the X axis direction, more specifically, the length of the N+ diffusion layer 55 and the P+ diffusion layer 53 in the X axis direction.

As shown in FIG. 5, in the semiconductor device 1b, the second dummy gate patterns 61-64 are arranged at cell boundaries of each cell parallel to the Y axis direction. The second dummy gate patterns 61-64 are dummy patterns that are not necessary for the functions of the inverter cells 2a-2b and the tap cell 5. Therefore, for example, a predetermined potential is not supplied to the second dummy gate patterns 61-64, and the potentials of the second dummy gate patterns 61-64 become floating.

The second dummy gate patterns 61-64 are dummy patterns arranged to maintain the periodicity of the layout pattern around the tap cell 5. The gate electrodes 22a-22b, the first dummy gate patterns 51-52, and the second dummy gate patterns 61-64 are arranged side by side in the X axis direction by arranging the second dummy gate patterns 61-64 at the cell boundaries of each cell parallel to the Y axis direction, and the periodicity of the layout pattern is maintained. The pattern transfer of the gate electrodes 22a-22b, the first dummy gate patterns 51-52, and the second dummy gate patterns 61-64 in which the periodicity of the layout pattern is maintained is performed by the same process, thereby suppressing variation in the pattern shape. As a result, the yield of the semiconductor device 1b can be improved, and variations in characteristics of the semiconductor device 1b can be suppressed.

As shown in FIG. 5, it is preferable to adjust the size of the tap cell 5, the arrangement positions of the first dummy gate patterns 51-52 in the tap cell 5, and the shapes of the first dummy gate patterns 51-52 so that the distances L9 between adjacent patterns in the gate electrodes 22a-22b, the first dummy gate patterns 51-52, and the second dummy gate patterns 61-64 are substantially the same.

As described above, according to the third embodiment, it is possible to stabilize the potential of the N-type well 11 and the potential of the P-type well 12 while maintaining the periodicity of the layout patterns of the gate electrodes 22a-22b in the periphery of the tap cell 5.

The third embodiment can also be combined with the second embodiment. That is, the sizes of the N+ diffusion layer 55 and the P+ diffusion layer 53 of the semiconductor device 1b according to the third embodiment can be reduced as the N+ diffusion layer 45 and the P+ diffusion layer 43 according to the second embodiment.

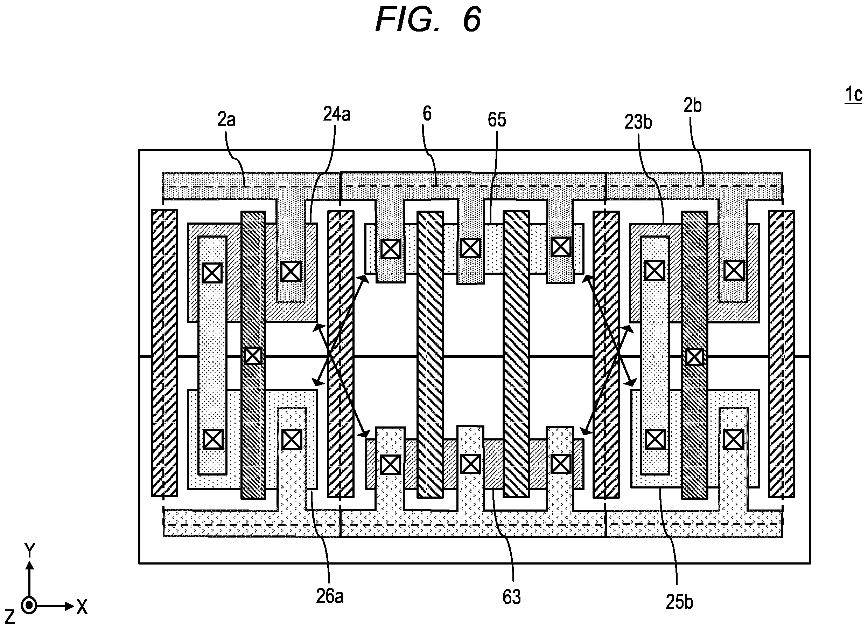

FIG. 6 is a plan view showing an example of a cell layout of a semiconductor device 1c according to a combination of the second embodiment and third embodiment. As shown in FIG. 6, in the semiconductor device 1c, the tap cell 5 of the semiconductor device 1b is changed to a tap cell 6. In addition, the N+ diffusion layer 55 and the P+ diffusion layer 53 of the semiconductor device 1b are changed to an N+ diffusion layer 65 and a P+ diffusion layer 63, respectively.

The size of the N+ diffusion layer 65 is set smaller than the maximum possible size on the region of the N-type well 11 in the tap cell 6. As a result, the distance between the N+ diffusion layer 65 and the N+ diffusion layer 26a, and the distance between the N+ diffusion layer 65 and the N+ diffusion layer 25b are sufficiently obtained. Further, the size of the P+ diffusion layer 63 is set smaller than the maximum possible size on the region of the P-type well 12 in the tap cell 6. As a result, the distance between the P+ diffusion layer 63 and the P+ diffusion layer 24a, and the distance between the P+ diffusion layer 63 and the P+ diffusion layer 23b are sufficiently obtained.

According to the semiconductor device 1c, while stabilizing the potential of the N-type well 11 and the potential of the P-type well 12, conduction of the same type of diffusion layers can be suppressed, and moreover, the periodicity of the layout pattern around the tap cell 6 can be maintained.

Although the invention made by the present inventor has been specifically described based on the embodiments, it is needless to say that the present invention is not limited to the above-described embodiments, and various changes may be made without departing from the scope thereof.

## Claims

1. Semiconductor device comprising:
a plurality of cells which is arranged along a first direction;
a first semiconductor layer which has a first conductivity type; and
a second semiconductor layer which has a second conductivity type,
wherein the plurality of the cells comprises:
a first basic logic cell;
a second basic logic cell; and
a tap cell which is arranged adjacently between the first and second basic logic cells,
wherein the first and second semiconductor layers are arranged along a second direction different from the first direction,
wherein each of the first and second basic logic cells comprises:
a gate electrode which is formed above the first and second semiconductor layers, and which extends in the second direction;
a first diffusion layer which is formed in a surface layer of the first semiconductor layer, and which has a second conductivity type;
a second diffusion layer which is formed in a surface layer of the first semiconductor layer, and which has a second conductivity type;
a third diffusion layer which is formed in a surface layer of the second semiconductor layer, and which has a first conductivity type; and
a fourth diffusion layer which is formed in a surface layer of the second semiconductor layer, and which has a first conductivity type,
wherein the first and second diffusion layers are arranged to sandwich a region of the first semiconductor layer covered by the gate electrode,
wherein the third and fourth diffusion layers are arranged to sandwich a region of the second semiconductor layer covered by the gate electrode,
wherein the tap cell comprises:
a fifth diffusion layer which is formed in a surface layer of the first semiconductor layer, and which has a first conductivity type;
a sixth diffusion layer which is formed in a surface layer of the second semiconductor layer, and which has a second conductivity type;
a dummy gate pattern which is formed above the fifth and sixth diffusion layers, and which extends in the second direction;
a first wiring layer which is formed above the first semiconductor layer; and
a second wiring layer which is formed above the second semiconductor layer,
which each of the fifth and sixth diffusion layers includes a first region covered by the dummy gate pattern and second and third regions not covered by the dummy gate patten,
wherein the second and third regions of the fifth diffusion layer are arranged to sandwich the first region of the fifth diffusion layer,
wherein the second and third regions of the sixth diffusion layer are arranged to sandwich the first region of the sixth diffusion layer,
wherein the first wiring layer is electrically connected to at least one of the second and third regions of the fifth diffusion layer, and
wherein the second wiring layer is electrically connected to at least one of the second and third regions of the sixth diffusion layer.

2. The semiconductor device according to Claim 1,
wherein the first wiring layer is applied with a first power supply potential,
wherein the second wiring layer is applied with a second power supply potential,
wherein the first wiring layer and the fifth diffusion layer constitute a first tap,
wherein the first tap supplies the first power supply potential to the first semiconductor layer via the first wiring layer and the fifth diffusion layer,
wherein the second wiring layer and the sixth diffusion layer constitute a second tap, and
wherein the second tap supplies the second power supply potential to the second semiconductor layer via the second wiring layer and the sixth diffusion layer.

3. The semiconductor device according to Claim 1 or 2, wherein the dummy gate pattern is a dummy pattern not related to a function of supplying the first power supply potential to the first semiconductor layer by the first tap and a function of supplying the second power supply potential to the second semiconductor layer by the second tap.

4. The semiconductor device according to any one of Claims 1 to 3, wherein a potential of the dummy gate pattern is floating.

5. The semiconductor device according to any one of Claims 1 to 4, wherein shapes of the gate electrode and the dummy gate pattern are substantially a same shape.

6. The semiconductor device according to any one of Claims 1 to 5, wherein pattern transfer of the gate electrode and the dummy date pattern is performed by a same process.

7. The semiconductor device according to any one of Claims 1 to 6,
wherein the gate electrode, the first diffusion layer and the second diffusion layer constitute a first transistor which has a second conductivity type, and
wherein the gate electrode, the third diffusion layer and the fourth diffusion layer constitute a second transistor which has a first conductivity type.

8. The semiconductor device according to any one of Claims 1 to 7,
wherein the first conductivity type comprises N-type, and
wherein the second conductivity type comprises P-Type.

9. The semiconductor device according to any one of Claims 1 to 8,
wherein shapes of the tap cell, the fifth diffusion layer and the sixth diffusion layer are quadrangles in a top view,
wherein the tap cell has first and second cell boundaries,
wherein the first and second semiconductor layers are arranged adjacent to each other,
wherein the first cell boundary is arranged on a first semiconductor side,
wherein the second cell boundary is arranged on a second semiconductor side,
wherein a length of the fifth diffusion layer in the second direction is set to be shorter than half a distance from the first boundary to a boundary between the first semiconductor layer and the second semiconductor layer, and
wherein a length of the sixth diffusion layer in the second direction is set to be shorter than half a distance from the second boundary to the boundary between the first semiconductor layer and the second semiconductor layer.

10. The semiconductor device according to any one of Claims 1 to 9,
wherein the dummy gate pattern comprises a first dummy gate pattern,
wherein the tap cell includes a plurality of the first dummy gate pattern,
wherein the semiconductor device comprises second dummy gate patterns which are arranged on a cell boundary between the first basic logic cell and the tap cell, and a cell boundary between the tap cell and the second basic logic cell.

11. The semiconductor device according to any one of Claims 1 to 10,
wherein the first basic logic cell comprises a first inverter cell,
wherein the second basic logic cell comprises a second inverter cell,
wherein the gate electrode of the first inverter cell is applied with a predetermined potential corresponding to an input signal to the first inverter cell, and
wherein the gate electrode of the second inverter cell is applied with a predetermined potential corresponding to an input signal to the second inverter cell.

12. The semiconductor device according to any one of Claims 1 to 11, wherein the first and second basic logic cells comprise inverters, buffers, AND circuits, NAND circuits, OR circuits and NOR circuits, or flip-flops.
